# EUROPEAN PATENT APPLICATION

(11) **EP 4 583 641 A1**
(43) Date of publication of application: **09.07.2025**
(21) Application number: 24804402.6
(22) Date of filing: 06.11.2024
(51) Int. Cl.: H05K 1/02, H05K 3/28, H04M 1/02

(54) **CIRCUIT BOARD AND ELECTRONIC DEVICE COMPRISING SAME**

(30) Priority: 17.11.2023 KR 20230159669; 12.12.2023 KR 20230179363
(71) Applicant: Samsung Electronics Co., Ltd, Suwon-si, Gyeonggi-do 16677 (KR)
(72) Inventor: LEE, Youngsun, Suwon-si, Gyeonggi-do 16677 (KR); KIM, Byeongkeol, Suwon-si, Gyeonggi-do 16677 (KR)
(74) Representative: Nederlandsch Octrooibureau
(86) International application number: PCT/KR2024/017397
(87) International publication number: WO 2025/105758

(57) **Abstract**

The disclosure relates to a circuit board. A circuit board according to an embodiment of the disclosure may comprise a base layer positioned in a first portion of the circuit board and a second portion of the circuit board different from the first portion of the circuit board, a power line positioned in the first portion of the circuit board, a signal line positioned in the second portion of the circuit board, a shielding layer spaced apart from the power line and the signal line, and a cover layer disposed between the base layer and the shielding layer. The cover layer may include a cover base layer positioned in the first portion and the second portion of the circuit board, a conductive layer positioned in the first portion of the circuit board to correspond to the power line, and disposed between the cover base layer and the shielding layer, and an insulating layer positioned in the second portion of the circuit board to correspond to the signal line, and disposed between the cover base layer and the shielding layer.

## Description

### [Technical Field]

Various embodiments of the disclosure relate to an electronic device, e.g., an electronic device including a circuit board. In particular, an electronic device including a flexible printed circuit board (PCB).

### [Background Art]

Advancing information communication and semiconductor technologies accelerate the spread and use of various electronic devices. In particular, recent electronic devices are being developed to carry out communication while a user carries the electronic device.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, an automobile navigation device, etc. For example, the electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function, such as for mobile banking, and a scheduling or e-wallet function. These electronic devices have been downsized to be conveniently carried by users.

An electronic device includes a housing and a circuit board disposed inside the housing. The electronic device includes a port insertion hole into which an external device (e.g., a USB or a charging device) may be inserted. The electronic device may be connected to an external device (e.g., a charging device) to charge the battery. The electronic device may include a flexible circuit board, such as a PCB, connecting the external device and the circuit board. The flexible circuit board includes a power line VBUS and a signal line USB3+. The power line VBUS of the flexible circuit board has direct current (DC) resistance, and the signal line USB3+ requires impedance matching.

The above-described information may be provided as related art for the purpose of helping understanding of the disclosure. No claim or determination is made as to whether any of the foregoing is applicable as background art in relation to the disclosure.

### [Disclosure of Invention]

### [Solution to Problems]

A circuit board according to an embodiment of the disclosure may comprise a base layer positioned in a first portion of the circuit board and a second portion of the circuit board different from the first portion of the circuit board, a power line positioned in the first portion of the circuit board, a signal line positioned in the second portion of the circuit board, a shielding layer spaced apart from the power line and the signal line, and a cover layer disposed between the base layer and the shielding layer. The cover layer may include a cover base layer positioned in the first portion and the second portion of the circuit board, a conductive layer positioned in the first portion of the circuit board to correspond to the power line, and disposed between the cover base layer and the shielding layer, and an insulating layer positioned in the second portion of the circuit board to correspond to the signal line, and disposed between the cover base layer and the shielding layer.

A circuit board according to an embodiment of the disclosure may comprise a power line positioned in a first portion of the circuit board, a signal line positioned in a second portion different from the first portion of the circuit board, and a cover layer spaced apart from the power line and the signal line. The cover layer may include a conductive layer positioned in the first portion of the circuit board to correspond to the power line and an insulating layer positioned in the second portion of the circuit board to correspond to the signal line.

An electronic device according to an embodiment of the disclosure may comprise a housing and a circuit board disposed inside the housing. The circuit board may include a base layer positioned in a first portion of the circuit board and a second portion of the circuit board different from the first portion of the circuit board, a power line positioned in the first portion of the circuit board, a signal line positioned in the second portion of the circuit board, a shielding layer spaced apart from the power line and the signal line, and a cover layer disposed between the base layer and the shielding layer. The cover layer may include a cover base layer positioned in the first portion and the second portion of the circuit board, a conductive layer positioned in the first portion of the circuit board to correspond to the power line, and disposed between the cover base layer and the shielding layer, and an insulating layer positioned in the second portion of the circuit board to correspond to the signal line, and disposed between the cover base layer and the shielding layer.

### [Brief Description of Drawings]

The foregoing and other aspects, configurations, and/or advantages of an embodiment of the disclosure will be more apparent from the following detailed description taken in conjunction with the accompanying drawings.
FIG. 1 is a block diagram illustrating an electronic device in a network environment according to various embodiments;
FIG. 2 is a perspective view illustrating an electronic device according to an embodiment of the disclosure;
FIG. 3 is a perspective view illustrating an electronic device according to an embodiment of the disclosure;
FIG. 4 is an exploded perspective view illustrating an electronic device according to an embodiment of the disclosure;
FIG. 5A is an exploded perspective view illustrating an electronic device according to an embodiment of the disclosure;
FIG. 5B is a partially exploded view illustrating an electronic device according to an embodiment of the disclosure;
FIG. 6 illustrates a portion of an electronic device according to an embodiment of the disclosure;
FIG. 7 is a cross-sectional view illustrating a portion of an electronic device according to an embodiment of the disclosure;
FIG. 8 is an enlarged view illustrating area M of FIG. 7;
FIG. 9 is a cross-sectional view illustrating a portion of an electronic device according to an embodiment of the disclosure;
FIG. 10 illustrates a portion of an electronic device according to an embodiment of the disclosure;
FIG. 11A is a cross-sectional view illustrating a portion of an electronic device according to an embodiment of the disclosure;
FIG. 11B is a cross-sectional view illustrating a portion of an electronic device according to an embodiment of the disclosure;
FIG. 12 is a block diagram illustrating a method for manufacturing an electronic device according to an embodiment of the disclosure; and
FIG. 13 is a cross-sectional view illustrating a portion of an electronic device according to an embodiment of the disclosure.

Throughout the drawings, like reference numerals may be assigned to like parts, components, and/or structures.

### [Mode for the Invention]

The following description taken in conjunction with the accompanying drawings may provide an understanding of various exemplary implementations of the disclosure, including claims and their equivalents. The specific embodiments disclosed in the following description entail various specific details to aid understanding, but are regarded as one of various embodiments. Accordingly, it will be understood by those skilled in the art that various changes and modifications may be made to the various implementations described in the disclosure without departing from the scope and spirit of the disclosure. Further, descriptions of well-known functions and configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided only for the purpose of description, not for the purpose of limiting the disclosure defined as the scope of the claims and equivalent thereto.

The singular forms "a," "an," and "the" are intended to include the plural forms as well, unless the context clearly indicates otherwise. Thus, as an example, "a component surface" may be interpreted as including one or more of the surfaces of a component.

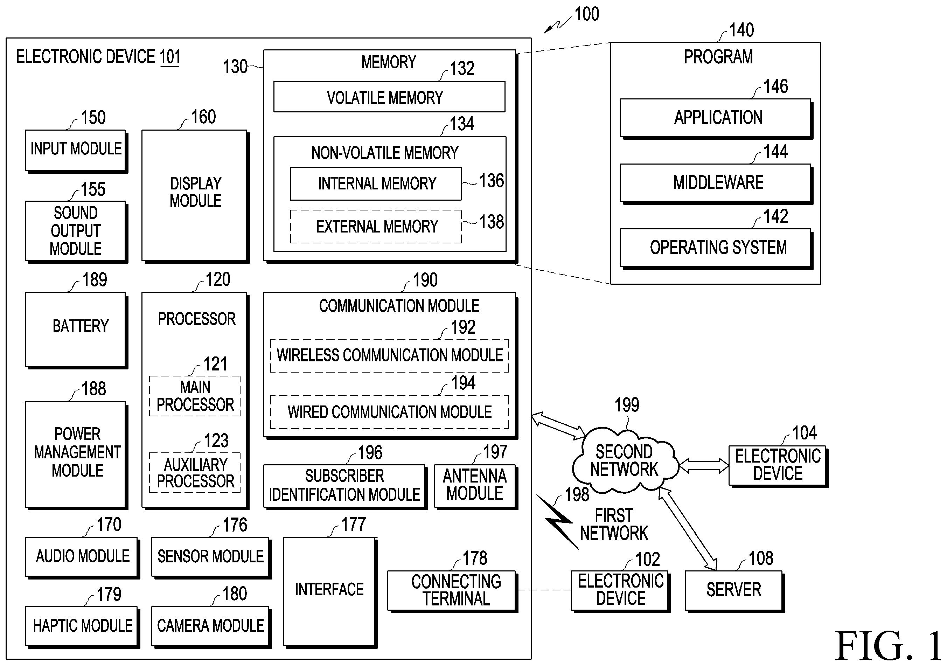

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

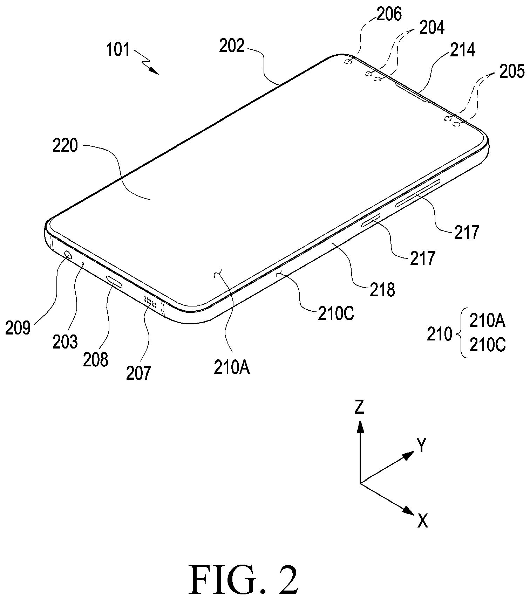

FIG. 2 is a front perspective view illustrating an electronic device according to an embodiment of the disclosure.

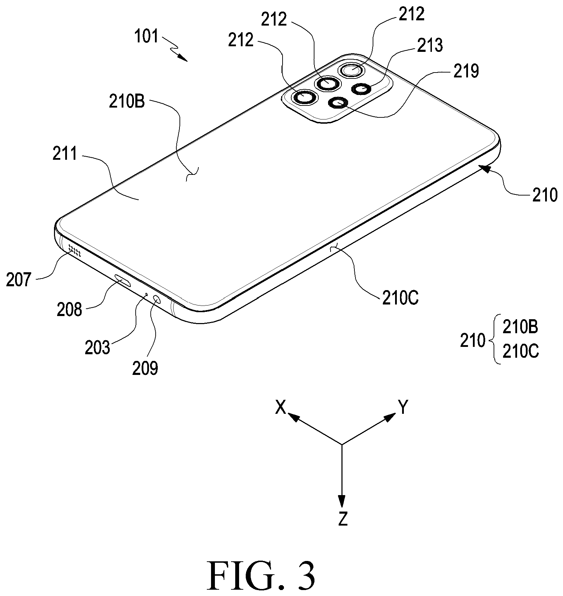

FIG. 3 is a rear perspective view illustrating an electronic device according to an embodiment of the disclosure.

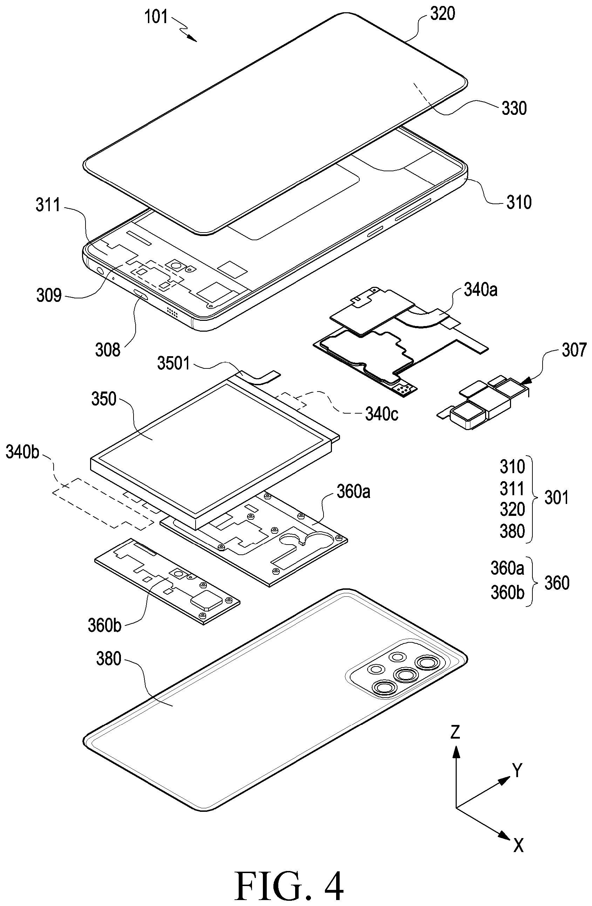

The embodiments of FIGS. 2 and 3 may be combined with the embodiment of FIG. 1 or the embodiments of FIGS. 4 to 13.

Referring to FIGS. 2 and 3, according to an embodiment, an electronic device 101 (e.g., the electronic device 101 of FIG. 1) may include a housing 210 including a first surface (or front surface) 210A, a second surface (or rear surface) 210B, and a side surface 210C surrounding a space between the first surface 210A and the second surface 210B. According to an embodiment (not illustrated), the housing 210 may denote a structure forming the first surface 210A of FIG. 2, the second surface 210B of FIG. 3, and some of the side surfaces 210C. According to an embodiment, at least part of the first surface 210A may have a substantially transparent front plate 202 (e.g., a glass plate or polymer plate including various coat layers). The second surface 210B may be formed by a rear plate 211 that is substantially opaque. The rear plate 211 may be formed of, e.g., laminated or colored glass, ceramic, polymer, metal (e.g., aluminum, stainless steel (STS), or magnesium), or a combination of at least two thereof. The rear plate 211 may form the second surface 210B. The side surface 210C may be formed by a side structure (or "side bezel structure") 218 that couples to the front plate 202 and the rear plate 211 and includes a metal and/or polymer. **In** an embodiment, the rear plate 211 and the side structure 218 may be integrally formed together and include the same material (e.g., a metal, such as aluminum).

Although not shown, the front plate 202 may include area(s) that bend from at least a portion of an edge toward the rear plate 211 and seamlessly extend. **In** an embodiment, only one of the areas of the front plate 202 (or the rear plate 211), which bend to the rear plate 211 (or front plate 202) and extend may be included in one edge of the first surface 210A. According to an embodiment, the front plate 202 or the rear plate 211 may have a substantially flat plate shape. For example, no bent and extended area may be included. When an area bending and extending is included, the thickness of the electronic device 101 at the portion including the area bending and extending may be smaller than the thickness of the rest.

According to an embodiment, the electronic device 101 may include at least one or more of a display 220, audio modules 203, 207, and 214, sensor modules 204 and 219, camera modules 205, 212, and 213, key input devices 217, a light emitting device 206, and connector holes 208 and 209. **In** an embodiment, the electronic device 101 may exclude at least one (e.g., the key input device 217 or the light emitting device 206) of the components or may add other components.

The display 220 may be visually exposed through a significant portion of the front plate 202. **In** an embodiment, at least a portion of the display 220 may be visually exposed through the front plate 202 forming the first surface 210A, or through a portion of the side surface 210C. **In** an embodiment, the edge of the display 220 may be formed to be substantially the same in shape as an adjacent outer edge of the front plate 202. **In** an embodiment (not illustrated), the interval between the outer edge of the display 220 and the outer edge of the front plate 202 may remain substantially even to give a larger area of visual exposure of the display 220.

**In** an embodiment (not shown), the screen display region of the display 220 may have a recess or opening in a portion thereof, and at least one or more of the audio module 214, sensor module 204, camera module 205, and light emitting device 206 may be aligned with the recess or opening. **In** an embodiment (not shown), at least one or more of the audio module 214, sensor module 204, camera module 205, fingerprint sensor (not shown), and light emitting device 206 may be included on the rear surface of the screen display area of the display 220. **In** an embodiment (not illustrated), the display 220 may be disposed to be coupled with, or adjacent, a touch detecting circuit, a pressure sensor capable of measuring the strength (pressure) of touches, and/or a digitizer for detecting a magnetic field-type stylus pen.

The audio modules 203, 207, and 214 may include a microphone hole 203 and speaker holes 207 and 214. A microphone for acquiring external sounds may be disposed in the microphone hole 203. **In** an embodiment, a plurality of microphones may be disposed to detect the direction of the sound. The speaker holes 207 and 214 may include an external speaker hole 207 and a phone receiver hole 214. **In** an embodiment, the speaker holes 207 and 214 and the microphone hole 203 may be implemented as a single hole, or speakers may be rested without the speaker holes 207 and 214 (e.g., piezo speakers).

The sensor modules 204 and 219 may generate an electrical signal or data value corresponding to an internal operating state or external environmental state of the electronic device 101. For example, the sensor modules 204 and 219 may include a first sensor module 204 (e.g., a proximity sensor) and/or a second sensor module (not shown) (e.g., a fingerprint sensor), which is disposed on the first surface 210A of the housing 210, and/or a third sensor module 219 and/or a fourth sensor module (e.g., a fingerprint sensor) disposed on the second surface 210B of the housing 210. The fingerprint sensor may be disposed on the second surface 210B or side surface 210C as well as the first surface 210A (e.g., the display 220) of the housing 210. The electronic device 101 may further include, e.g., at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 205, 212, and 213 may include a first camera device 205 disposed on the first surface 210A of the electronic device 101, and a second camera device 212 and/or a flash 213 disposed on the second surface 210B. The camera devices 205 and 212 may include one or more lenses, an image sensor, and/or an image signal processor. The flash 213 may include, e.g., a light emitting diode (LED) or a xenon lamp. In an embodiment, two or more lenses (an infrared (IR) camera, a wide-angle lens, and a telescopic lens) and image sensors may be disposed on one surface of the electronic device 101. In an embodiment, flash 213 may emit infrared light. The infrared light emitted by the flash 213 and reflected by the subject may be received through the third sensor module 219. The electronic device 101 or the processor of the electronic device 101 may detect depth information about the subject based on the time point when the infrared light is received from the third sensor module 219.

The key input device 217 may be disposed on the side surface 210C of the housing 210. In an embodiment, the electronic device 101 may exclude all or some of the above-mentioned key input devices 217 and the excluded key input devices 217 may be implemented in other forms, e.g., as soft keys, on the display 220. In an embodiment, the key input device may include the sensor module disposed on the second surface 210B of the housing 210.

The light emitting device 206 may be disposed on, e.g., the first surface 210A of the housing 210. The light emitting device 206 may provide, e.g., information about the state of the electronic device 101 in the form of light. In an embodiment, the light emitting device 206 may provide a light source that interacts with, e.g., the camera module 205. The light emitting device 206 may include, e.g., a light emitting diode (LED), an infrared (IR) LED, or a xenon lamp.

The connector holes 208 and 209 may include a first connector hole 208 for receiving a connector (e.g., a universal serial bus (USB) connector) for transmitting or receiving power and/or data to/from an external electronic device and/or a second connector hole 209 (e.g., an earphone jack) for receiving a connector for transmitting or receiving audio signals to/from the external electronic device.

FIG. 4 is a front exploded perspective view illustrating an electronic device according to an embodiment of the disclosure.

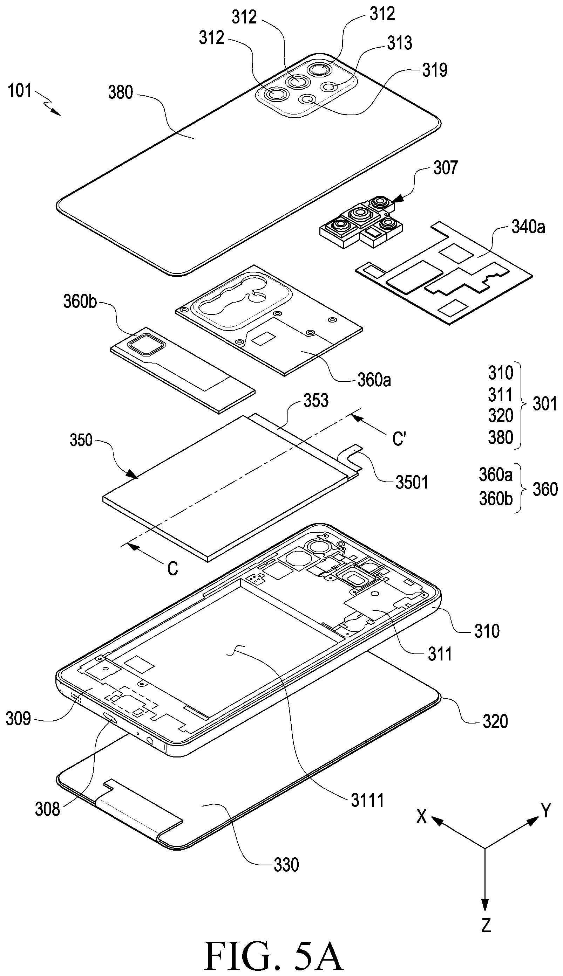

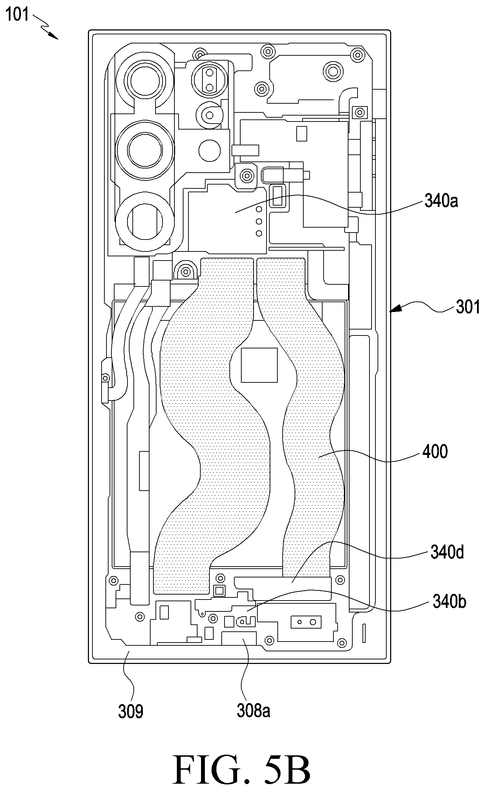

FIG. 5 is a rear exploded perspective view illustrating an electronic device according to an embodiment of the disclosure.

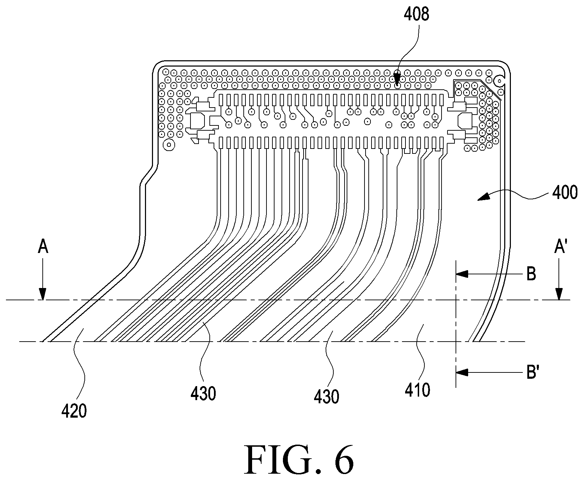

The embodiments of FIGS. 4 and 5 may be combined with the embodiments of FIGS. 1 to 3 or the embodiments of FIGS. 6 to 13.

Referring to FIGS. 3 and 4, an electronic device 101 (e.g., the electronic device 101 of FIG. 1 or FIG. 2) may include a side structure 310, a first supporting member 311 (e.g., a bracket), a front plate 320 (e.g., the front plate 202 of FIG. 1), a display 330 (e.g., the display 220 of FIG. 1), at least one printed circuit board (or a board assembly) 340a or 340b, a battery 350, a second supporting member 360 (e.g., a rear case), an antenna, a camera assembly 307, and a rear plate 380 (e.g., the rear plate 211 of FIG. 2). When the plurality of printed circuit boards 340a and 340b are included, the electronic device 101 may include at least one flexible printed circuit board 340c to electrically connect different printed circuit boards. For example, the printed circuit boards 340a and 340b may include a first circuit board 340a disposed above the battery 350 (e.g., in the +Y-axis direction) and a second circuit board 340b disposed under the battery 350 (e.g., in the -Y-axis direction), and the flexible circuit board 340c may electrically connect the first circuit board 340a and the second circuit board 340b.

According to an embodiment, the electronic device 101 may exclude at least one (e.g., the first supporting member 311 or the second supporting member 360) of the components or may add other components. At least one of the components of the electronic device 101 may be the same or similar to at least one of the components of the electronic device 101 of FIG. 1 or 2 and no duplicate description is made below.

At least a portion of the first supporting member 311 may be provided in a flat plate shape. In an embodiment, the first supporting member 311 may be disposed inside the electronic device 101 to be connected with the side structure 310 or integrated with the side structure 310. The first supporting member 311 may be formed of, e.g., a metallic material and/or non-metallic material (e.g., polymer). When the first supporting member 311 is at least partially formed of a metallic material, a portion of the side structure 310 or the first supporting member 311 may function as an antenna. The display 330 may be joined onto one surface of the first supporting member 311, and the printed circuit boards 340a and 340b may be joined onto the opposite surface of the first supporting member 311. A processor, memory, and/or interface may be mounted on the printed circuit boards 340a and 340b. The processor may include one or more of, e.g., a central processing unit, an application processor, a graphic processing device, an image signal processing, a sensor hub processor, or a communication processor.

According to an embodiment, the housing 301 may include a first supporting member 311 and a side structure 310. According to an embodiment, the housing 301 may be understood as a structure for receiving, protecting, or disposing the printed circuit boards 340a and 340b or the battery 350. In an embodiment, the housing 301 may be understood as including a structure that the user may visually or tactfully recognize from the exterior of the electronic device 101, e.g., the side structure 310, the front plate 320, and/or the rear plate 380. For example, the housing 301 may include structures (e.g., the side structure 310, the front plate 320, and the rear plate 380) forming the appearance of the electronic device 101. The housing 301 may be identical to the housing 210 described in connection with FIGS. 2 and 3. In an embodiment, the 'front or rear surface of the housing 301' may refer to the first surface 210A of FIG. 1 or the second surface 210B of FIG. 2. In an embodiment, the first supporting member 311 may be disposed between the front plate 320 (e.g., the first surface 210A of FIG. 2) and the rear plate 380 (e.g., the second surface 210B of FIG. 3) and may function as a structure for placing an electrical/electronic component, such as the printed circuit boards 340a and 340b or the camera assembly 307.

The memory may include, e.g., a volatile or non-volatile memory.

The interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

The second supporting member 360 may include, e.g., an upper supporting member 360a or a lower supporting member 360b. In an embodiment, the upper supporting member 360a, together with a portion of the first supporting member 311, may be disposed to surround the printed circuit boards 340a and 340b (e.g., the first circuit board 340a). For example, the upper supporting member 360a of the second supporting member 360 may be disposed to face the first supporting member 311 with the first circuit board 340a interposed therebetween. In an embodiment, the lower supporting member 360b of the second supporting member 360 may be disposed to face the first supporting member 311 with the second circuit board 340b interposed therebetween. A circuit device (e.g., a processor, a communication module, or a memory) implemented in the form of an integrated circuit chip or various electrical/electronic components may be disposed on the printed circuit boards 340a and 340b. According to an embodiment, the printed circuit boards 340a and 340b may receive an electromagnetic shielding environment from the second supporting member 360. In an embodiment, the lower supporting member 360b may be utilized as a structure in which electrical/electronic components, such as a speaker module, or an interface (e.g., a USB connector, an SD card/MMC connector, or an audio connector) may be disposed. In an embodiment, electrical/electronic components, such as a speaker module, or an interface (e.g., a USB connector, an SD card/MMC connector, or an audio connector) may be disposed on an additional printed circuit board (not shown). For example, the lower supporting member 360b, together with the other part of the first supporting member 311, may be disposed to surround the additional printed circuit board (e.g., the second printed circuit board 340b). The speaker module or interface disposed on the additional printed circuit board (not shown) or the lower supporting member 360b may be disposed corresponding to the audio module 207 or connector holes 208 and 309 of FIG. 2.

The battery 350 may be a device for supplying power to at least one component of the electronic device 101. The battery 189 may include, e.g., a primary cell which is not rechargeable, a secondary cell which is rechargeable, or a fuel cell. At least a portion of the battery 350 may be disposed on substantially the same plane as the printed circuit boards 340a and 340b. The battery 350 may be integrally or detachably disposed inside the electronic device 101.

Although not shown, the antenna may include a conductor pattern implemented on the surface of the second supporting member 360 through, e.g., laser direct structuring. **In an** embodiment, the antenna may include a printed circuit pattern formed on the surface of the thin film. The thin film-type antenna may be disposed between the rear plate 380 and the battery 350. The antenna may include, e.g., a near-field communication (NFC) antenna, a wireless charging antenna, and/or a magnetic secure transmission (MST) antenna. The antenna may perform short-range communication with, e.g., an external device or may wirelessly transmit or receive power necessary for charging. In an embodiment of the present invention, another antenna structure may be formed by a portion or combination of the side structure 310 and/or the first supporting member 311.

According to an embodiment, the camera assembly 307 may include at least one camera module. Inside the electronic device 101, the camera assembly 307 (or at least one camera module) may receive at least a portion of the light incident through the optical hole or camera windows. In an embodiment, the camera assembly 307 may be disposed on the first supporting member 311 in a position adjacent to the printed circuit boards 340a and 340b. **In** an embodiment, the camera module(s) of the camera assembly 307 may be generally aligned with either one of the camera windows and be a least partially surrounded by the second supporting member 360 (e.g., the upper supporting member 360a).

According to an embodiment, the electronic device 101 may include camera holes 312, 313, and 319. A plurality of camera holes 312, 313, and 319 may be disposed to be spaced apart from each other. The camera assembly 307 may receive light passing through the camera holes 312, 313, and 319.

According to an embodiment, the first supporting member 311 may include an accommodation portion 3111. The battery 350 may be disposed in the accommodation portion 3111. The battery 350 may include a terrace 353. The terrace 353 may protrude toward the printed circuit board 340. The battery 350 may include a battery connection member 3501 connecting the terrace 353 and the printed circuit board 340.

According to an embodiment, the electronic device 101 may include a port insertion hole 308. The port insertion hole 308 may be open in a portion of the housing 301. The port insertion hole 308 may communicate with an outer space of the housing 301. The electronic device 101 may be connected to an external device (e.g., a USB port, a charging line, or the like), and the external device may be inserted into the port insertion hole 308.

According to an embodiment, the electronic device 101 may include an antenna 309. The antenna 309 may be disposed adjacent to the port insertion hole 308.

FIG. 5B is a view illustrating a state in which a rear cover (e.g., the rear plate 380 of FIG. 5A) of the electronic device 101 is removed. Some or all of the components described with reference to FIG. 5B may be the same as all or some of the components described with reference to FIGS. 1 to 5A. Some or all of the components described with reference to FIG. 5B may be the same as all or some of the components described with reference to FIGS. 6 to 13.

According to an embodiment, the electronic device 101 may include a first printed circuit board 340a, a second printed circuit board 340b, and a flexible printed circuit board 340c. The description of the printed circuit boards 340a, 340b, and 340c described with reference to FIGS. 1 to 5A may be identically applied to the description of the printed circuit boards (e.g., the first printed circuit board 340a, the second printed circuit board 340b, and the flexible printed circuit board 340c).

According to an embodiment, the first printed circuit board 340a and the second printed circuit board 340b may be disposed inside the housing 301. The first printed circuit board 340a and the second printed circuit board 340b may be spaced apart from each other. The flexible printed circuit board 340c may connect the first printed circuit board 340a and the second printed circuit board 340b.

According to an embodiment, the electronic device 101 may include a circuit board 400. The circuit board 400 may be a flexible printed circuit board. The circuit board 400 may be disposed inside the housing 301. The flexible circuit board 340c described with reference to FIGS. 1 to 5A may be the same as the circuit board 400 described with reference to FIGS. 5B to 13. The circuit board 400 may connect the first printed circuit board 340a and the second printed circuit board 340b.

According to an embodiment, the circuit board 400 may be disposed inside the housing 301. The circuit board 400 may be connected to the second printed circuit board 340b. The circuit board 400 may connect the first printed circuit board 340a and the second printed circuit board 340b. The circuit board 400 may transfer a signal related to power transferred from an external device (e.g., a charging device) inserted through the port insertion hole 308. The circuit board 400 may transfer power of an external device (e.g., a charging device) inserted through the port insertion hole 308. The circuit board 400 may transfer a signal transferred from an external device (e.g., USB) inserted through the port insertion hole 308 to the first printed circuit board 340a. The circuit board 400 may transfer a signal transferred from the antenna 309 to the first printed circuit board 340a.

According to an embodiment, the electronic device 101 may include a device connector 308a. The device connector 308a may face the port insertion hole 308. The device connector 308a may be coupled to the second printed circuit board 340b. An external device (e.g., a charging device or a USB) inserted into the port insertion hole 308 may be connected to the device connector 308a. The device connector 308a may connect the external device and the second printed circuit board 340b.

According to an embodiment, the electronic device 101 may include a substrate connector 340d. The substrate connector 340d may be coupled to the second printed circuit board 340b. The substrate connector 340d may connect the second printed circuit board 340b and the circuit board 400. At least a portion of the circuit board 400 may be inserted into the substrate connector 340d.

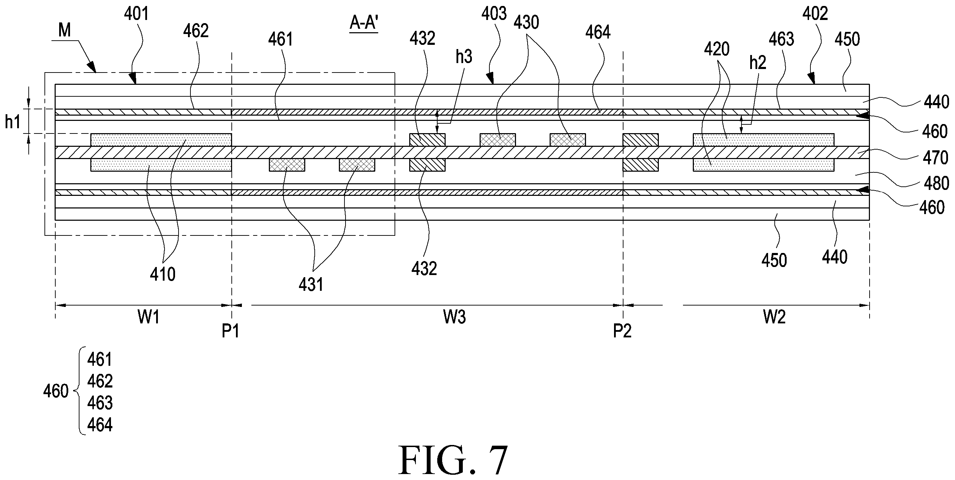

FIG. 6 is a view illustrating a portion of the circuit board 400. Some or all of the components described with reference to FIG. 6 may be the same as all or some of the components described with reference to FIGS. 1 to 5B. Some or all of the components described with reference to FIG. 6 may be the same as all or some of the components described with reference to FIGS. 7 to 13. FIG. 6 may be a view illustrating a state in which the shielding layer 440 and the film layer 450 illustrated in FIG. 7 are removed.

According to an embodiment, the circuit board 400 may include power lines 410 and 420. The power lines 410 and 420 may supply power to a battery (e.g., the battery 350 of FIGS. 1 to 5A). The power lines 410 and 420 may include a plurality of power lines 410 and 420. The power lines 410 and 420 may include a first power line 410 and a second power line 420. The first power line 410 and the second power line 420 may be spaced apart from each other. The power line 410 and 420 may be referred to as a "first line". The power line 410 and 420 may be referred to as a "first signal line". The power line 410 and 420 may be referred to as a "charging line". The power line 410 and 420 may be referred to as a "VBUS line".

According to an embodiment, the circuit board 400 may include a signal line 430. The signal line 430 may transfer a signal to a first printed circuit board (e.g., the first printed circuit board 340a of FIG. 5B). The signal line 430 may receive a signal from an external device (e.g., a USB port) inserted into a port insertion hole (e.g., the port insertion hole 308 of FIG. 5B). The signal line 430 may be disposed between the first power line 410 and the second power line 420. The signal line 430 may be referred to as a "second line". The signal line 430 may be referred to as a "second signal line". The signal line 430 may be referred to as a "USB line". The signal line 430 may be referred to as a "communication line". The signal line 430 may be referred to as a "data line".

According to an embodiment, the electronic device 101 may include a connecting pin 408. The connecting pin 408 may be coupled to the circuit board 400. The connecting pin 408 may be coupled to a substrate connector (e.g., the substrate connector 340d of FIG. 5B). The connecting pin 408 may connect the second printed circuit board (e.g., the second printed circuit board 340b of FIG. 5B) and the circuit board 400. The signal generated from the external device (e.g., the signal related to the information transferred through the USB or the power transferred through the charging device) may be transferred to the circuit board 400 through the connecting pin 408.

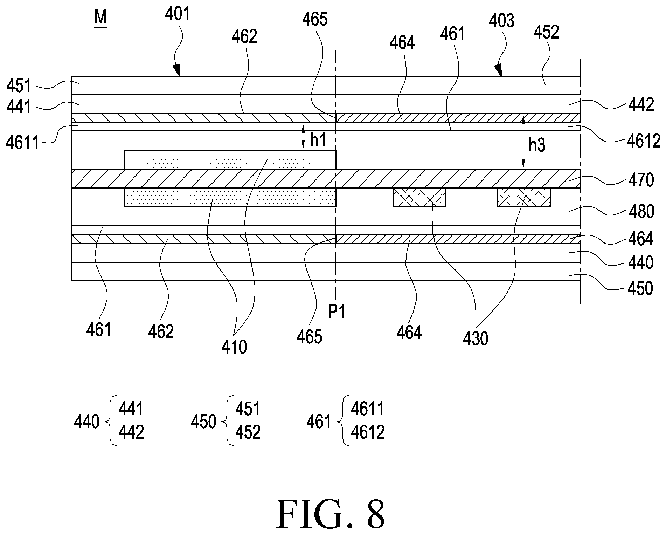

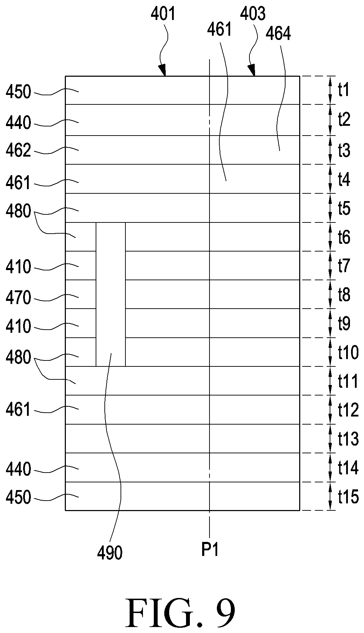

FIG. 7 is a cross-sectional view illustrating a circuit board 400 taken along reference line A-A' illustrated in FIG. 6. FIG. 8 is an enlarged view of area M illustrated in FIG. 7. Some or all of the components described with reference to FIGS. 7 and 8 may be the same as all or some of the components described with reference to FIGS. 1 to 6. Some or all of the components described with reference to FIGS. 7 and 8 may be the same as all or some of the components described with reference to FIGS. 9 to 13.

According to an embodiment, the circuit board 400 may include first portions 401 and 402. The first portions 401 and 402 may be portions of the circuit board 400. The first portions 401 and 402 may be portions of the circuit board 400 on which the power line 410 is disposed. The first portions 401 and 402 may include a plurality of first portions 401 and 402. For example, the first portions 401 and 402 may include a 1-1th portion 401 and a 1-2th portion 402 spaced apart from each other.

According to an embodiment, the circuit board 400 may include a second portion 403. The second portion 403 may be a portion of the circuit board 400. The second portion 403 may be a portion of the circuit board 400 on which the signal line 430 is disposed. The second portion 403 may be positioned between the 1-1th portion 401 and the 1-2th portion 402.

According to an embodiment, the circuit board 400 may include power lines 410 and 420 and a signal line 430. The power lines 410 and 420 may include a first power line 410 and a second power line 420. The power lines 410 and 420 may be disposed in the first portions 401 and 402. The first power line 410 may be disposed in the 1-1th portion 401. The second power line 420 may be disposed in the 1-2th portion 402. The signal line 430 may be disposed in the second portion 403.

According to an embodiment, the signal line 430 may include a signal line 431 and a ground line 432. The signal line 431 and the ground line 432 may be connected to each other indirectly. The circuit board 400 may include a connection line (not shown) connecting the signal line 431 and the ground line 432. The signal line 431 and the ground line 432 may be connected to each other through the connection line.

According to an embodiment, the circuit board 400 may include a base layer 470. The base layer 470 may be positioned inside the circuit board 400. The power lines 410 and 420 and the signal line 430 may be coupled to the base layer 470. The power lines 410 and 420 may be disposed between the base layer 470 and the cover layer 460. The signal line 430 may be disposed between the base layer 470 and the cover layer 460.

According to an embodiment, the circuit board 400 may include an adhesive layer 480. The adhesive layer 480 may be adhered to the base layer 470. The adhesive layer 480 may surround at least a portion of the power lines 410 and 420 and the signal line 430. The adhesive layer 480 may be disposed between the base layer 470 and the cover layer 460. The adhesive layer 480 may connect the base layer 470 and the cover layer 460.

According to an embodiment, the circuit board 400 may include a shielding layer 440. The shielding layer 440 may block a signal outside the circuit board 400. The shielding layer 440 may block electro-magnetic interference (EMI). The shielding layer 440 may be disposed between the film layer 450 and the cover layer 460. The shielding layer 440 may be referred to as a "barrier layer". The shielding layer 440 may be referred to as a "shielding layer" or a "protection layer".

According to an embodiment, the circuit board 400 may include a film layer 450. The film layer 450 may form a surface of the circuit board 400. The film layer 450 may be coupled to the shielding layer 440. The film layer 450 may be referred to as a "surface layer". The film layer450th may be referred to as a "protective layer". The film layer450th may be referred to as an "outer layer".

According to an embodiment, the circuit board 400 may include a cover layer 460. The cover layer 460 may be spaced apart from the base layer 470. The cover layer 460 may be disposed between the base layer 470 and the shielding layer 440. The cover layer 460 may be disposed between the adhesive layer 480 and the shielding layer 440.

According to an embodiment, the shielding layer 440, the film layer 450, and the cover layer 460 may be disposed symmetrically with respect to the base layer 470. For example, the shielding layer 440 may include a plurality of shielding layers 440 spaced apart from each other with the base layer 470 interposed therebetween. For example, the film layer 450 may include a plurality of film layers 450 spaced apart from each other with the base layer 470 interposed therebetween. For example, the cover layer 460 may include a plurality of cover layers 460 spaced apart from each other with the base layer 470 interposed therebetween.

According to an embodiment, the cover layer 460 may include a cover base layer 461. The cover base layer 461 may be disposed between the base layer 470 and the shielding layer 440. The cover base layer 461 may be disposed between the adhesive layer 480 and the shielding layer 440. The adhesive layer 480 may be attached to the cover base layer 461. The cover base layer 461 may be positioned to correspond to all of the first portions 401 and 402 and the second portion 403 of the circuit board 400. For example, a portion of the cover base layer 461 may be positioned in the first portions 401 and 402, and another portion of the cover base layer 461 may be positioned in the second portion 403.

According to an embodiment, the cover layer 460 may include conductive layers 462 and 463. The conductive layers 462 and 463 may include a conductive material. The conductive layers 462 and 463 may include a copper (Cu) material. The conductive layers 462 and 463 may be disposed between the base layer 470 and the shielding layer 440. The conductive layers 462 and 463 may be disposed between the cover base layer 461 and the shielding layer 440. The conductive layers 462 and 463 may be disposed between the power lines 410 and 420 and the shielding layer 440. The conductive layers 462 and 463 may be positioned in the first portions 401 and 402 of the circuit board 400. The conductive layers 462 and 463 may include a first conductive layer 462 positioned in the 1-1th portion 401 and a second conductive layer 463 positioned in the 1-2th portion 402. The first conductive layer 462 may be disposed between the first power line 410 and the shielding layer 440. The second conductive layer 463 may be disposed between the second power line 420 and the shielding layer 440.

According to an embodiment, the cover layer 460 may include an insulating layer 464. The insulating layer 464 may include a dielectric material. The insulating layer 464 may include a non-conductive material. The insulating layer 464 may include a material having a dielectric constant. The insulating layer 464 may be disposed between the base layer 470 and the shielding layer 440. The insulating layer 464 may be disposed between the cover base layer 461 and the shielding layer 440. The insulating layer 464 may be disposed between the signal line 430 and the shielding layer 440. The insulating layer 464 may be positioned in the second portion 403 of the circuit board 400. The insulating layer 464 may be referred to as a "non-conductive layer". The insulating layer 464 may be referred to as a "dielectric layer". The insulating layer 464 may be referred to as an "insertion layer".

According to an embodiment, the conductive layers 462 and 463 and the insulating layer 464 may be positioned on the same plane. For example, the conductive layers 462 and 463 and the insulating layer 464 may be disposed between the cover base layer 461 and the shielding layer 440. The insulating layer 464 may be disposed between the first conductive layer 462 and the second conductive layer 463.

According to an embodiment, the cover layer 460 may include a first cover layer 461 and second cover layers 462, 463, and 464. The cover base layer 461 may be referred to as a "first cover layer". Each of the conductive layers 462 and 463 and the insulating layer 464 may be referred to as a "second cover layer". The second cover layers 462, 463, and 464 may include conductive layers 462 and 463 and an insulating layer 464. The conductive layers 462 and 463 may be referred to as "conductive portions". The insulating layer 464 may be referred to as an "insulating portion". The conductive portions 462 and 463 may include a first conductive portion 462 and a second conductive portion 463.

According to an embodiment, boundary surfaces P1 and P2 may be formed between the first portions 401 and 402 and the second portion 403 of the circuit board 400. For example, a first boundary surface P1 may be formed between the 1-1th portion 401 and the second portion 403. For example, a second boundary surface P2 may be formed between the 1-2th portion 402 and the second portion 403. The first and second interfaces P1 and P2 may be virtual planes separating the portions 401, 402, and 403 of the circuit board 400. The first power line 410 may be positioned in a first direction with respect to the first interface P1, and the signal line 430 may be positioned in a second direction opposite to the first direction with respect to the interface P1. The second power line 420 may be positioned in the second direction with respect to the second interface P2, and the signal line 430 may be positioned in the first direction with respect to the second interface P2.

According to an embodiment, the width w1 of the 1-1th portion 401 may be smaller than the width w3 of the second portion 403. The width w2 of the 1-2th portion 402 may be smaller than the width w3 of the second portion 403.

According to an embodiment, the cover base layer 461 may include a first cover portion 4611 and a second cover portion 4612. The first cover portion 4611 and the second cover portion 4612 may be integrated. The first cover portion 4611 may be a portion of the cover base layer 461 positioned in the first portion 401. The second cover portion 4612 may be a portion of the cover base layer 461 positioned in the second portion 403. The first cover portion 4611 and the second cover portion 4612 may be bordered by the boundary surface P1. The first cover portion 4611 may be disposed between the power line 410 and the conductive layer 462. The first cover portion 4611 may be positioned to correspond to the power line 410. The first cover portion 4611 may be positioned to correspond to the conductive layer 462. The second cover portion 4612 may be disposed between the signal line 430 and the insulating layer 464. The second cover portion 4612 may be positioned to correspond to the signal line 430. The second cover portion 4612 may be positioned to correspond to the insulating layer 464.

According to an embodiment, the shielding layer 440 may include a first shielding portion 441 and a second shielding portion 442. The first shielding portion 441 and the second shielding portion 442 may be integrated. The first shielding portion 441 may be a portion of the shielding layer 440 positioned in the first portion 401. The second shielding portion 442 may be a portion of the shielding layer 440 positioned in the second portion 403. The first shielding portion 441 and the second shielding portion 442 may be bordered by the boundary surface P1. The first shielding portion 441 may be disposed between the power line 410 and the film layer 450. The first shielding portion 441 may be disposed between the conductive layer 462 and the film layer 450. The first shielding portion 441 may be positioned to correspond to the power line 410. The first shielding portion 441 may be positioned to correspond to the conductive layer 462. The second shielding portion 442 may be disposed between the signal line 430 and the film layer 450. The second shielding portion 442 may be positioned to correspond to the signal line 430. The second shielding portion 442 may be positioned to correspond to the insulating layer 464.

According to an embodiment, the film layer 450 may include a first film portion 451 and a second film portion 452. The first film portion 451 and the second film portion 452 may be integrated. The first film portion 451 may be a portion of the film layer 450 positioned in the first portion 401. The second film portion 452 may be a portion of the film layer 450 positioned in the second portion 403. The first film portion 451 and the second film portion 452 may be bordered by the boundary surface P1. The first film portion 451 may be positioned to correspond to the power line 410. The first film portion 451 may be positioned to correspond to the conductive layer 462. The second film portion 452 may be positioned to correspond to the signal line 430. The second film portion 452 may be positioned to correspond to the insulating layer 464.

According to an embodiment, the power line 410 may be disposed between the base layer 470 and the first cover portion 4611. The power line 410 may be disposed between the base layer 470 and the conductive layer 462. The power line 410 may be disposed between the base layer 470 and the first shielding portion 441. The power line 410 may be disposed between the base layer 470 and the first film portion 451.

According to an embodiment, the signal line 430 may be disposed between the base layer 470 and the second cover portion 4612. The signal line 430 may be disposed between the base layer 470 and the insulating layer 464. The signal line 430 may be disposed between the base layer 470 and the second shielding portion 442. The signal line 430 may be disposed between the base layer 470 and the second film portion 452.

According to an embodiment, the conductive layer 462 may be disposed between the first cover portion 4611 and the first shielding portion 441. The conductive layer 462 may be disposed between the power line 410 and the first shielding portion 441. The conductive layer 462 may be disposed between the power line 410 and the first film portion 451. The conductive layer 462 may be disposed between the first cover portion 4611 and the first film portion 451.

According to an embodiment, the insulating layer 464 may be disposed between the second cover portion 4612 and the second shielding portion 442. The insulating layer 464 may be disposed between the signal line 430 and the second shielding portion 442. The insulating layer 464 may be disposed between the signal line 430 and the second film portion 452. The insulating layer 464 may be disposed between the second cover portion 4612 and the second film portion 452.

According to an embodiment, the cover layer 460 may include a first cover layer 461 and second cover layers 462, 463, and 464. The second cover layers 462, 463, and 464 may include a boundary portion 465. The boundary portion 465 may form a boundary between the conductive layer 462 and the insulating layer 464. The boundary surface P1 may be formed to pass through the boundary portion 465.

According to an embodiment, the conductive layer 462 may be disposed at a position corresponding to the power line 410. The insulating layer 464 may be formed at a position corresponding to the signal line 430. First gaps h1 and h2 between the power lines 410 and 420 and the conductive layers 462 and 463 may be smaller than a second gap h3 between the signal line 430 and the shielding layer 440.

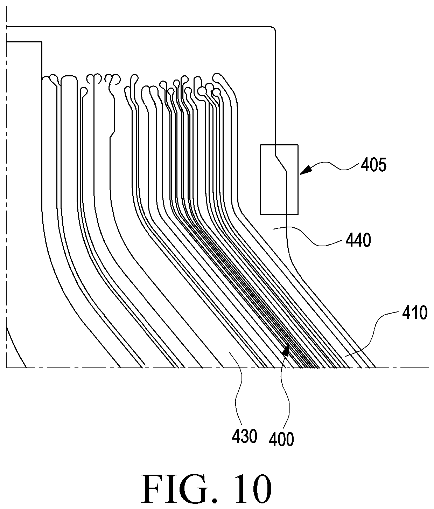

FIG. 9 is a view conceptually illustrating a relationship between layers of a circuit board 400 illustrated in FIGS. 7 and 8. Some or all of the components described with reference to FIG. 9 may be the same as those described with reference to FIGS. 1 to 8. Some or all of the components described with reference to FIG. 9 may be the same as all or some of the components described with reference to FIGS. 10 to 13.

According to an embodiment, the circuit board 400 may include a first portion 401 and a second portion 403. The description of the first portion 401, 402, and 403 described with reference to FIGS. 7 and 8 may be identically applied to the description of the first portion 401 and the second portion 403.

According to an embodiment, the circuit board 400 may include a conductive via 490. The conductive via 490 may penetrate at least a portion of the circuit board 400. The conductive via 490 may provide a ground to the power line 410. The conductive via 490 may penetrate the power line 410. The conductive via 490 may be connected to the adhesive layer 480. The conductive via 490 may be referred to as a "ground line".

According to an embodiment, the layers 410, 440, 450, 461, 462, 464, 470, and 480 constituting the circuit board 400 may have thicknesses t1 to t15. The thicknesses t7 and t9 of the power line 410 may be smaller than the thickness t8 of the base layer 470. The thicknesses t4 and t12 of the cover base layer 461 may be larger than the thicknesses t7 and t9 of the power line 410. The thicknesses t4 and t12 of the cover base layer 461 may be larger than the thicknesses t3 and t13 of the conductive layer 462. The thicknesses t4 and t12 of the cover base layer 461 may be larger than the thicknesses t3 and t13 of the insulating layer 464. The thicknesses t3 and t13 of the conductive layer 462 may be substantially the same as the thicknesses t3 and t13 of the insulating layer 464. The thickness t8 of the base layer 470 may range from 10um to 14um. The thickness t8 of the base layer 470 may be 12um. The thicknesses t7 and t9 of the power line 410 may range from 5 µm to 7 µm. The thicknesses t7 and t9 of the power line 410 may be 6um. The thicknesses t4 and t12 of the cover base layer 461 may range from 6um to 9um. The thicknesses t4 and t12 of the cover base layer 461 may be 7.5 um. The thicknesses t3 and t13 of the conductive layer 462 may range from 4um to 6um. The thicknesses t3 and t13 of the conductive layer 462 may be 5um. The thicknesses t3 and t13 of the insulating layer 464 may range from 4um to 6um. The thicknesses t3 and t13 of the insulating layer 464 may be 5um.

The circuit board 400 according to an embodiment of the disclosure may produce a desired DC resistance of the power lines 410 and 420 due to the above-described structure. The circuit board 400 according to an embodiment of the disclosure may enhance charging efficiency of a battery (e.g., the battery 350 of FIG. 5A) through the power lines 410 and 420 due to the above-described structure. The circuit board 400 according to an embodiment of the disclosure may produce a desired amount of heat generated in the power lines 410 and 420 due to the above-described structure. The circuit board 400 according to an embodiment of the disclosure may maintain a separation distance between the signal line 430 and the shielding layer 440 due to the above-described structure. The circuit board 400 according to an embodiment of the disclosure may secure a sufficient impedance for the signal line 430 due to the above-described structure. In the circuit board 400 according to an embodiment of the disclosure, the shielding effect of EMI for the power line 410 and the signal line 430 may be enhanced due to the above-described structure. For example, the circuit board 400 according to an embodiment of the disclosure may further dispose the second power line 420 by disposing the first conductive layer 462 in the 1-1th portion 401 in which the first power line 410 is disposed to form a charging line structure between the first conductive layer 462 and the first power line 410. For example, the circuit board 400 according to an embodiment of the disclosure may increase the length (e.g., the sum W1+W2 of the first width W1 and the second width W2 of FIG. 7) of all the power lines 410 and 420 by disposing the second power line 420 in addition to the first power line 410. For example, the circuit board 400 according to an embodiment of the disclosure may reduce DC resistance generated in the power lines 410 and 420 by increasing the length W1+W2 of all the power lines 410 and 420. Therefore, the length W1+W2 may be configured to generate a desired DC resistance in the power lines 410 and 420. As a result of the length W1+W2 and the desired DC resistance, circuit board 400 maintains signal integrity. For example, the circuit board 400 according to an embodiment of the disclosure may secure a sufficient distance (e.g., the gap h3 of FIG. 7) between the signal line 430 and the shielding layer 440 by disposing the insulating layer 464 having a permittivity in the second portion 403 in which the signal line 430 is disposed. For example, the circuit board 400 according to an embodiment of the disclosure may provide sufficient impedance to the signal line 430 by securing a sufficient distance h3 between the signal line 430 and the shielding layer 440.

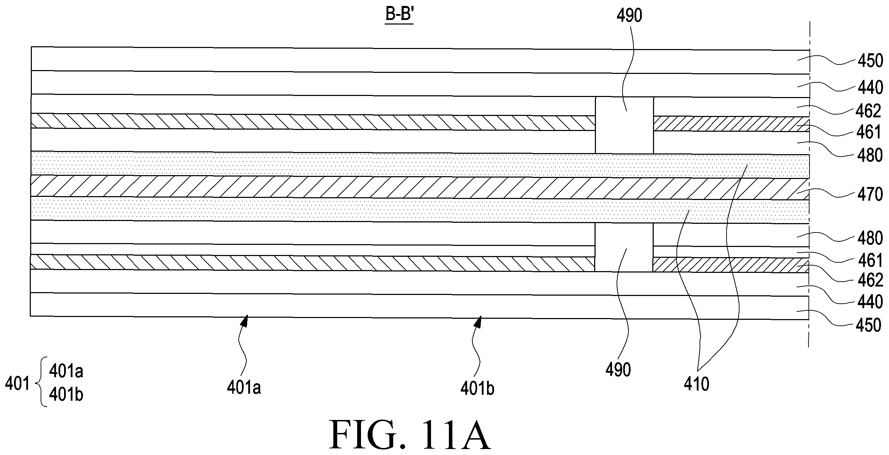

FIG. 10 is an enlarged view of a portion of the circuit board 400. Some or all of the components described with reference to FIG. 10 may be the same as those described with reference to FIGS. 1 to 9. Some or all of the components described with reference to FIG. 10 may be the same as all or some of the components described with reference to FIGS. 11A to 13.

According to an embodiment, a circuit board 400 may include a power line 410, a signal line 430, and a shielding layer 440. The description of the components (e.g., the power line 410, the signal line 430, and the shielding layer 440) described with reference to FIGS. 7 to 9 may be identically applied to the description of the above-described components (e.g., the power line 410, the signal line 430, and the shielding layer 440).

According to an embodiment, the circuit board 400 may include a ground portion 405. The ground portion 405 may be formed at a position corresponding to the power line 410. The ground portion 405 may include a portion of the shielding layer 440.

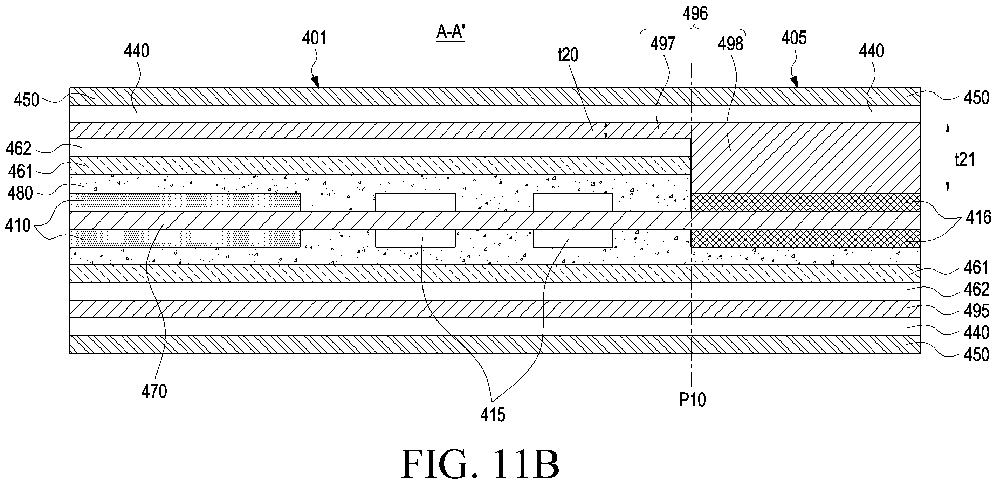

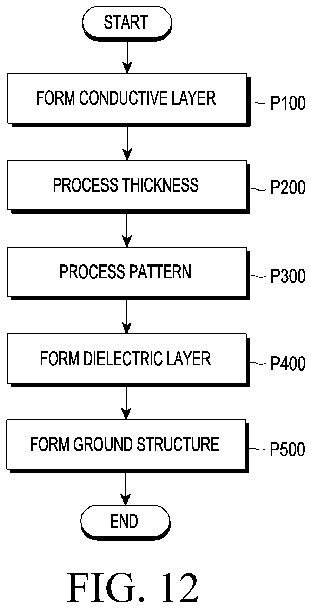

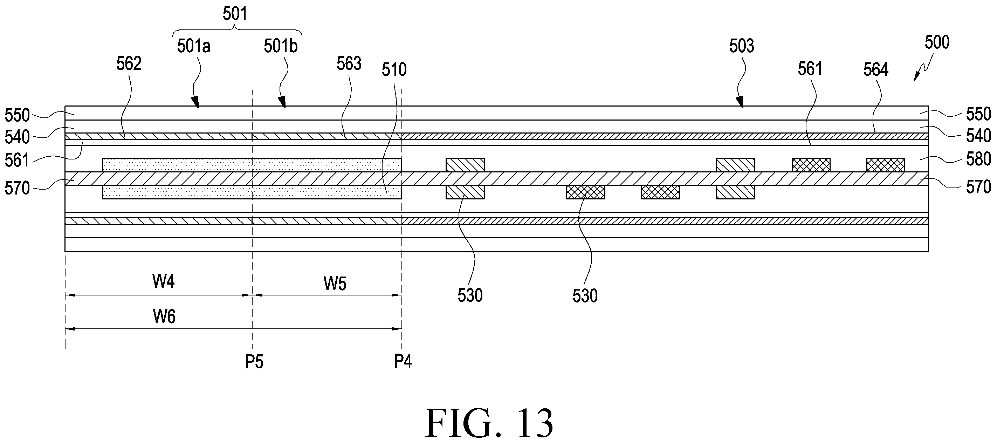

FIG. 11A is a cross-sectional view illustrating a circuit board 400 taken along reference line B-B' illustrated in FIG. 6. FIG. 11B is a cross-sectional view illustrating the circuit board 400 taken along reference line A-A' illustrated in FIG. 6. Some or all of the components described with reference to FIGS. 11A and 11B may be the same as all or some of the components described with reference to FIGS. 1 to 9. Some or all of the components described with reference to FIGS. 11A and 11B may be the same as all or some of the components described with reference to FIGS. 12 and 13.

According to an embodiment, the circuit board 400 may include layers 410, 440, 450, 461, 462, 470, and 480 stacked on each other. The description of the layers (e.g., the power line 410, the shielding layer 440, the film layer 450, the cover base layer 461, the conductive layer 462, the base layer 470, and the adhesive layer 480) described with reference to FIGS. 7 to 9 may be identically applied to the description of the layers 410, 440, 450, 461, 462, 470, and 480.

According to an embodiment, the circuit board 400 may include a ground line 490. The ground line 490 may pass through at least a portion of the circuit board 400. The ground line 490 may connect the power line 410 and the shielding layer 440. The ground line 490 may penetrate the cover base layer 461 and the adhesive layer 480.

According to an embodiment, the first portion 401 may include a power supply portion 401a and a ground line portion 401b. The power supply portion 401a and the ground line portion 401b may be integrated. The ground line 490 may be disposed in the ground line portion 401b.

According to an embodiment, the circuit board 400 may include a first portion 401 and a ground portion 405. The first portion 401 and the ground portion 405 may be bordered by the boundary surface P10. The boundary surface P10 may be a virtual plane that borders the first portion 401 and the ground portion 405.

According to an embodiment, the circuit board 400 may include conductive adhesive layers 495 and 496. At least a portion of the conductive adhesive layers 495 and 496 may be disposed between the conductive layer 462 and the shielding layer 440. The conductive adhesive layers 495 and 496 may include a first conductive adhesive layer 495 and a second conductive adhesive layer 496 disposed at positions, respectively, opposite to each other with respect to the base layer 470.

According to an embodiment, the conductive adhesive layer 496 may include a first conductive adhesive portion 497 positioned in the first portion 401. The conductive adhesive layer 496 may include a second conductive adhesive portion 498 positioned in the ground portion 405. The first conductive adhesive portion 497 and the second conductive adhesive portion 498 may be integrated. The boundary surface P10 may border the first conductive adhesive portion 497 and the second conductive adhesive portion 498. The thickness t20 of the first conductive adhesive portion 497 may be smaller than the thickness t21 of the second conductive adhesive portion 498. The second conductive adhesive portion 498 may be disposed in a space formed by cutting off at least a portion of the cover layer 460.

According to an embodiment, the circuit board 400 may include a circuit component 415. The circuit component 415 may be positioned in the first portion 401. The circuit component 415 may be connected to the power line 410. The circuit board 400 may include a ground layer 416. The ground layer 416 may be connected to the power line 410 and the circuit component 415. The ground layer 416 may be coupled to the base layer 470. The ground layer 416 may be disposed between the conductive adhesive layer 496 and the base layer 470. The power line 410, the circuit component 415, and the ground layer 416 may be positioned on substantially the same plane.

According to an embodiment, the conductive adhesive layer 496 may provide a ground line to the power line 410. The second conductive adhesive portion 498 may be disposed between the shielding layer 440 and the ground layer 416. The second conductive adhesive portion 498 may connect the shielding layer 440 and the ground layer 416.

FIG. 12 is a block diagram illustrating a method for manufacturing a circuit board 400 according to an embodiment of the disclosure. Some or all of the components described with reference to FIG. 12 may be the same as all or some of the components described with reference to FIGS. 1 to 11B. Some or all of the components described with reference to FIG. 12 may be the same as all or some of the components described with reference to FIG. 13.

According to an embodiment, a method for manufacturing the circuit board 400 may include an operation P100 of forming a conductive layer. The operation P100 of forming the conductive layer may include an operation of manufacturing an integrated conductive plate including the conductive layers 462 and 463 illustrated in FIGS. 7 to 11B.

According to an embodiment, the method for manufacturing the circuit board 400 may include an operation P200 of processing the thickness of the cover layer. The operation P200 of processing the thickness of the cover layer may include an operation of adjusting the thickness of the conductive plate. The conductive plate may be processed by a thickness required for impedance matching of the signal line 430. The conductive plate may be processed by an etching method.

According to an embodiment, the method for manufacturing the circuit board 400 may include an operation P300 of processing the pattern of the cover layer. The operation P300 of processing the pattern of the cover layer may include an operation of cutting off a portion of the conductive plate. The conductive plate may be processed by an etching method. The operation P300 of processing the pattern of the cover layer may include an operation of cutting off a portion corresponding to the signal line 430 illustrated in FIGS. 7 and 8. After the cut-off operation, a first conductive layer 462 and a second conductive layer 463 spaced apart from each other may be formed.

According to an embodiment, the method for manufacturing the circuit board 400 may include an operation P400 of forming a dielectric layer. The operation P400 of forming the dielectric layer may include an operation of applying the insulating layer 464 illustrated in FIGS. 7 and 8 to the cut-off portion of the conductive plate. The operation P400 of forming the dielectric layer may include an operation of applying an insulating material between the first conductive layer 462 and the second conductive layer 463.

According to an embodiment, the method for manufacturing the circuit board 400 may include an operation P500 of forming a ground line. The operation P500 of forming the ground line may include an operation of grounding the power lines 410 and 420 and the conductive layers 462 and 463. The operation P500 of forming the ground line may include an operation of disposing the ground lines 490, 495, and 496 illustrated in FIGS. 11A and 11B.

FIG. 13 is a cross-sectional view illustrating a circuit board 500 according to an embodiment of the disclosure. Some or all of the components described with reference to FIG. 13 may be the same as those described with reference to FIGS. 1 to 12.

According to an embodiment, the circuit board 500 may include a base layer 570, a signal line 530, a shielding layer 540, a film layer 550, a cover base layer 561, and an adhesive layer 580. The description of the components (e.g., the base layer 470, the signal line 430, the shielding layer 440, the film layer 450, the cover base layer 461, and the adhesive layer 480) described with reference to FIGS. 1 to 12 may be identically applied to the description of the above-described components (e.g., the base layer 570, the signal line 530, the shielding layer 540, the film layer 550, the cover base layer 561, and the adhesive layer 580).

According to an embodiment, the circuit board 500 may include a first portion 501 and a second portion 503. The description of the first and second portions 401 and 403 described with reference to FIGS. 1 to 12 may be identically applied to the description of the first and second portions 501 and 503. The power line 510 may be positioned in the first portion 501. The signal line 530 may be positioned in the second portion 503. The cover base layer 561 may be positioned to correspond to both the first portion 501 and the second portion 503.

According to an embodiment, the circuit board 500 may include an insulating layer 564 positioned in the second portion 503. The description of the insulating layer 464 described with reference to FIGS. 1 to 12 may be identically applied to the description of the insulating layer 564. The insulating layer 564 may be disposed between the signal line 530 and the shielding layer 540.

According to an embodiment, the circuit board 500 may include conductive layers 562 and 563 positioned in the first portion 501. The description of the conductive layers 462 and 463 described with reference to FIGS. 1 to 12 may be equally applied to the description of the conductive layers 562 and 563. The conductive layers 562 and 563 may be disposed between the power line 510 and the shielding layer 540.

The circuit board 500 of FIG. 13 may differ in that the first conductive layer 562 and the second conductive layer 563 are integratedly elongated, from the circuit board 400 of FIG. 7. For example, the circuit board 500 may include integrated conductive layers 562 and 563. The length W6 of the first portion 501 of the circuit board 500 of FIG. 13 may be larger than the length w1 of the 1-1th portion 401 or the length w2 of the 1-2th portion 402 of the circuit board 400 of FIG. 7. The conductive layers 562 and 563 may be integratedly elongated, and may be larger than the length of the first conductive layer 462 or the second conductive layer 463 illustrated in FIG. 7.

According to an embodiment, the first portion 501 and the second portion 503 may be bordered by the boundary surface P4. The first portion 501 may be divided into a 1-1th portion 501a and a 1-2th portion 501b with respect to the boundary surface P5 positioned inside the first portion 501. The 1-1th portion 501a and the 1-2th portion 501b are arbitrarily divided for convenience of description, and the 1-1th portion 501a and the 1-2th portion 501b may form an integrated first portion 501. The conductive layers 562 and 563 may be divided into a first conductive layer 562 positioned in the 1-1th portion 501a and a second conductive layer 563 positioned in the 1-2th portion 501b. The sum w6 of the length w4 of the 1-1th portion 501a and the length w5 of the 1-2th portion 501b may be substantially equal to the sum of the length w1 of the 1-1th portion 401 and the length w2 of the 1-2th portion 402 illustrated in FIG. 7.

An electronic device includes a housing and a circuit board disposed inside the housing. The electronic device includes a port insertion hole into which an external device (e.g., a USB or a charging device) may be inserted. The electronic device may be connected to an external device (e.g., a charging device) to charge the battery. The electronic device may include a flexible circuit board connecting the external device and the circuit board. The flexible circuit board includes a power line VBUS and a signal line USB3+. The power line VBUS of the flexible circuit board has direct current (DC) resistance, and the signal line USB3+ requires impedance matching.

An object of the disclosure may be to generate a desired DC resistance of the power line.

An object of the disclosure may be to match the impedance of the signal line.

The objects of the disclosure are not limited to those mentioned herein, but may be determined in various manners without departing from the spirit or scope of the disclosure.

An electronic device according to various embodiments of the disclosure may generate a desired DC resistance of a power line by disposing a conductive layer at a position corresponding to the power line.

An electronic device according to various embodiments of the disclosure may match the impedance of a signal line by disposing an insulating layer at a position corresponding to the signal line.

Effects obtainable from the disclosure are not limited to the above-mentioned effects, and other effects not mentioned may be apparent to one of ordinary skill in the art from the following description.

A circuit board (e.g., 400 of FIGS. 1 to 13) according to an embodiment of the disclosure may comprise a base layer (e.g., 470 of FIGS. 1 to 13) positioned in a first portion (e.g., 401 or 402 of FIGS. 1 to 13) of the circuit board (e.g., 400 of FIGS. 1 to 13) and a second portion (e.g., 403 of FIGS. 1 to 13) different from the first portion (e.g., 401 or 402 of FIGS. 1 to 13).

The circuit board (e.g., 400 of FIGS. 1 to 13) according to an embodiment of the disclosure may comprise a power line (e.g., 410 and 420 of FIGS. 1 to 13) positioned in the first portion (e.g., 401 or 402 of FIGS. 1 to 13) of the circuit board (e.g., 400 of FIGS. 1 to 13).

The circuit board (e.g., 400 of FIGS. 1 to 13) according to an embodiment of the disclosure may comprise a signal line (e.g., 430 of FIGS. 1 to 13) positioned in the second portion (e.g., 403 of FIGS. 1 to 13) of the circuit board (e.g., 400 of FIGS. 1 to 13).

The circuit board (e.g., 400 of FIGS. 1 to 13) according to an embodiment of the disclosure may comprise a shielding layer (e.g., 440 of FIGS. 1 to 13) spaced apart from the power line (e.g., 410 and 420 of FIGS. 1 to 13) and the signal line (e.g., 430 of FIGS. 1 to 13).

The circuit board (e.g., 400 of FIGS. 1 to 13) according to an embodiment of the disclosure may comprise a cover layer (e.g., 460 of FIGS. 1 to 13) disposed between the base layer (e.g., 470 of FIGS. 1 to 13) and the shielding layer (e.g., 440 of FIGS. 1 to 13).

The cover layer (e.g., 460 of FIGS. 1 to 13) according to an embodiment of the disclosure may include a cover base layer (e.g., 461 of FIGS. 1 to 13) positioned in the first portion (e.g., 401 or 402 of FIGS. 1 to 13) and the second portion (e.g., 403 of FIGS. 1 to 13) of the circuit board (e.g., 400 of FIGS. 1 to 13).

The cover layer (e.g., 460 of FIGS. 1 to 13) according to an embodiment of the disclosure may include a conductive layer (e.g., 462 or 463 of FIGS. 1 to 13) disposed in the first portion (e.g., 401 or 402 of FIGS. 1 to 13) of the circuit board (e.g., 400 of FIGS. 1 to 13) to correspond to the power line (e.g., 410 or 420 of FIGS. 1 to 13) and disposed between the cover base layer (e.g., 461 of FIGS. 1 to 13) and the shielding layer (e.g., 440 of FIGS. 1 to 13).

The cover layer (e.g., 460 of FIGS. 1 to 13) according to an embodiment of the disclosure may include an insulating layer (e.g., 464 of FIGS. 1 to 13) positioned in the second portion (e.g., 403 of FIGS. 1 to 13) of the circuit board (e.g., 400 of FIGS. 1 to 13) to correspond to the signal line (e.g., 430 of FIGS. 1 to 13) and disposed between the cover base layer (e.g., 461 of FIGS. 1 to 13) and the shielding layer (e.g., 440 of FIGS. 1 to 13).

The conductive layer (e.g., 462 or 463 of FIGS. 1 to 13) according to an embodiment of the disclosure may be positioned between the power line (e.g., 410 or 420 of FIGS. 1 to 13) and the shielding layer (e.g., 440 of FIGS. 1 to 13).

The insulating layer (e.g., 464 of FIGS. 1 to 13) according to an embodiment of the disclosure may be positioned between the signal line (e.g., 410 or 420 of FIGS. 1 to 13) and the shielding layer (e.g., 440 of FIGS. 1 to 13).

The power line (e.g., 410 or 420 of FIGS. 1 to 13) according to an embodiment of the disclosure may include a first power line (e.g., 410 of FIGS. 1 to 13).

The power line (e.g., 410 or 420 of FIGS. 1 to 13) according to an embodiment of the disclosure may include a second power line (e.g., 420 of FIGS. 1 to 13) spaced apart from the first power line (e.g., 410 of FIGS. 1 to 13).

The conductive layer (e.g., 462 or 463 of FIGS. 1 to 13) according to an embodiment of the disclosure may include a first conductive layer (e.g., 462 of FIGS. 1 to 13) corresponding to the first power line (e.g., 410 of FIGS. 1 to 13).

The conductive layer (e.g., 462 or 463 of FIGS. 1 to 13) according to an embodiment of the disclosure may include a second conductive layer (e.g., 463 of FIGS. 1 to 13) corresponding to the second power line (e.g., 420 of FIGS. 1 to 13).

The conductive layer (e.g., 462 or 463 of FIGS. 1 to 13) according to an embodiment of the disclosure may include a first conductive layer (e.g., 462 of FIGS. 1 to 13) and a second conductive layer (e.g., 463 of FIGS. 1 to 13) spaced apart from each other.

The insulating layer (e.g., 464 of FIGS. 1 to 13) according to an embodiment of the disclosure may be disposed between the first conductive layer (e.g., 462 of FIGS. 1 to 13) and the second conductive layer (e.g., 463 of FIGS. 1 to 13).

The cover layer (e.g., 460 of FIGS. 1 to 13) according to an embodiment of the disclosure may include a boundary portion (e.g., 465 of FIGS. 1 to 13) where the conductive layer (e.g., 462 or 463 of FIGS. 1 to 13) and the insulating layer (e.g., 464 of FIGS. 1 to 13) are connected.

The conductive layer (e.g., 462 or 463 of FIGS. 1 to 13) and the insulating layer (e.g., 464 of FIGS. 1 to 13) according to an embodiment of the disclosure may have substantially the same thickness.

The cover base layer (e.g., 461 of FIGS. 1 to 13) according to an embodiment of the disclosure may include a first cover portion (e.g., 4611 of FIGS. 1 to 13) corresponding to the conductive layer (e.g., 462 or 463 of FIGS. 1 to 13).

The cover base layer (e.g., 461 of FIGS. 1 to 13) according to an embodiment of the disclosure may include a second cover portion (e.g., 4612 of FIGS. 1 to 13) corresponding to the insulating layer (e.g., 464 of FIGS. 1 to 13).

The shielding layer (e.g., 440 of FIGS. 1 to 13) according to an embodiment of the disclosure may include a first shielding portion (e.g., 441 of FIGS. 1 to 13) corresponding to the conductive layer (e.g., 462 or 463 of FIGS. 1 to 13).

The shielding layer (e.g., 440 of FIGS. 1 to 13) according to an embodiment of the disclosure may include a second shielding portion (e.g., 442 of FIGS. 1 to 13) corresponding to the insulating layer (e.g., 464 of FIGS. 1 to 13).

The circuit board (e.g., 400 of FIGS. 1 to 13) according to an embodiment of the disclosure may comprise a ground line (e.g., 490 of FIGS. 1 to 13) connecting the shielding layer (e.g., 440 of FIGS. 1 to 13) and the power line (e.g., 410 and 420 of FIGS. 1 to 13).

The circuit board (e.g., 400 of FIGS. 1 to 13) according to an embodiment of the disclosure may comprise a conductive adhesive layer (e.g., 496 of FIGS. 1 to 13) at least partially disposed between the cover layer (e.g., 460 of FIGS. 1 to 13) and the shielding layer (e.g., 440 of FIGS. 1 to 13) and connected to the power line (e.g., 410 or 420 of FIGS. 1 to 13).

The conductive adhesive layer (e.g., 496 of FIGS. 1 to 13) according to an embodiment of the disclosure may include a first conductive adhesive portion (e.g., 497 of FIGS. 1 to 13) disposed between the cover layer (e.g., 460 of FIGS. 1 to 13) and the shielding layer (e.g., 440 of FIGS. 1 to 13).

The conductive adhesive layer (e.g., 496 of FIGS. 1 to 13) according to an embodiment of the disclosure may include a second conductive adhesive portion (e.g., 498 of FIGS. 1 to 13) extending from the first conductive adhesive portion (e.g., 497 of FIGS. 1 to 13) and connecting the shielding layer (e.g., 440 of FIGS. 1 to 13) and the power lines (e.g., 410 or 420 of FIGS. 1 to 13).

The conductive layer (e.g., 462 or 463 of FIGS. 1 to 13) according to an embodiment of the disclosure may be electrically connected to the power line (e.g., 410 or 420 of FIGS. 1 to 13) and may be configured to provide a ground to the power line (e.g., 410 or 420 of FIGS. 1 to 13).

A first gap (e.g., h1 or h2 of FIGS. 1 to 13) between the power line (e.g., 410 or 420 of FIGS. 1 to 13) and the conductive layer (e.g., 462 or 463 of FIGS. 1 to 13) according to an embodiment of the disclosure may be smaller than a second gap (e.g., h3 of FIGS. 1 to 13) between the signal line (e.g., 430 of FIGS. 1 to 13) and the shielding layer (e.g., 440 of FIGS. 1 to 13).

A circuit board (e.g., 400 of FIGS. 1 to 13) according to an embodiment of the disclosure may include an adhesive layer (e.g., 480 of FIGS. 1 to 13) disposed between the power line (e.g., 410 or 420 of FIGS. 1 to 13) and the cover layer (e.g., 460 of FIGS. 1 to 13) and surrounding the power line (e.g., 410 or 420 of FIGS. 1 to 13).

The circuit board (e.g., 400 of FIGS. 1 to 13) according to an embodiment of the disclosure may comprise a power line (e.g., 410 or 420 of FIGS. 1 to 13) positioned in a first portion (e.g., 401 or 402 of FIGS. 1 to 13) of the circuit board (e.g., 400 of FIGS. 1 to 13).

The circuit board (e.g., 400 of FIGS. 1 to 13) according to an embodiment of the disclosure may comprise a signal line (e.g., 430 of FIGS. 1 to 13) positioned in a second portion (e.g., 403 of FIGS. 1 to 13) different from the first portion (e.g., 401 and 402 of FIGS. 1 to 13) of the circuit board (e.g., 400 of FIGS. 1 to 13).

The circuit board (e.g., 400 of FIGS. 1 to 13) according to an embodiment of the disclosure may comprise a cover layer (e.g., 460 of FIGS. 1 to 13) spaced apart from the power line (e.g., 410 or 420 of FIGS. 1 to 13) and the signal line (e.g., 430 of FIGS. 1 to 13).

The cover layer (e.g., 460 of FIGS. 1 to 13) according to an embodiment of the disclosure may comprise a conductive layer (e.g., 462 or 463 of FIGS. 1 to 13) positioned in the first portion (e.g., 401 or 402 of FIGS. 1 to 13) of the circuit board (e.g., 400 of FIGS. 1 to 13) to correspond to the power line (e.g., 410 or 420 of FIGS. 1 to 13).

According to an embodiment of the disclosure, the cover layer (e.g., 460 of FIGS. 1 to 13) may include an insulating layer (e.g., 464 of FIGS. 1 to 13) positioned in the second portion (e.g., 403 of FIGS. 1 to 13) of the circuit board (e.g., 400 of FIGS. 1 to 13) to correspond to the signal line (e.g., 410 or 420 of FIGS. 1 to 13).

An electronic device (e.g., 101 of FIGS. 1 to 13) according to an embodiment of the disclosure may comprise a housing (e.g., 301 of FIGS. 1 to 13).

The electronic device (e.g., 101 of FIGS. 1 to 13) according to an embodiment of the disclosure may comprise a circuit board (e.g., 400 of FIGS. 1 to 13) disposed inside the housing (e.g., 301 of FIGS. 1 to 13).

While the disclosure has been shown and described with reference to exemplary embodiments thereof, it will be apparent to those of ordinary skill in the art that various changes in form and detail may be made thereto without departing from the spirit and scope of the disclosure as defined by the following claims.

While the disclosure has been described and shown in connection with an embodiment thereof, it should be appreciated that an embodiment is intended as limiting the invention but as illustrative. It will be apparent to one of ordinary skill in the art that various changes may be made in form and detail without departing from the overall scope of the disclosure, including the appended claims and their equivalents.

## Claims

1. A circuit board (400) comprising:
a base layer (470) positioned in a first portion (401, 402) of the circuit board (400) and a second portion (403) of the circuit board (400) different from the first portion (401, 402) of the circuit board (400);
a power line (410, 420) positioned in the first portion (401, 402) of the circuit board (400);
a signal line (430) positioned in the second portion (403) of the circuit board (400);
a shielding layer (440) spaced apart from the power line (410, 420) and the signal line (430); and
a cover layer (460) disposed between the base layer (470) and the shielding layer (440), wherein the cover layer (460) includes:
a cover base layer (461) positioned in the first portion (401, 402) and the second portion (403) of the circuit board (400);
a conductive layer (462, 463) positioned in the first portion (401, 402) of the circuit board (400) to correspond to the power line (410, 420), and disposed between the cover base layer (461) and the shielding layer (440); and
an insulating layer (464) positioned in the second portion (403) of the circuit board (400) to correspond to the signal line (430), and disposed between the cover base layer (461) and the shielding layer (440).

2. The circuit board (400) of claim 1,
wherein the conductive layer (462, 463) is positioned between the power line (410, 420) and the shielding layer (440).

3. The circuit board (400) of claim 1 or 2,
wherein the insulating layer (464) is positioned between the signal line (430) and the shielding layer (440).

4. The circuit board (400) of any one of claims 1 to 3,
wherein the power line (410, 420) includes:
a first power line (410); and
a second power line (420) spaced apart from the first power line (410), and
wherein the conductive layer (462, 463) includes:
a first conductive layer (462) corresponding to the first power line (410); and
a second conductive layer (463) corresponding to the second power line (420).

5. The circuit board (400) of any one of claims 1 to 4,
wherein the conductive layer (462, 463) includes a first conductive layer (462) and a second conductive layer (463) spaced apart from each other, and
wherein the insulating layer (464) is disposed between the first conductive layer (462) and the second conductive layer (463).

6. The circuit board (400) of any one of claims 1 to 5,
wherein the cover layer (460) includes a boundary portion (465) where the conductive layer (462, 463) and the insulating layer (464) are connected.

7. The circuit board (400) of any one of claims 1 to 6,
wherein the conductive layer (462, 463) and the insulating layer (464) have substantially the same thickness.

8. The circuit board (400) of any one of claims 1 to 7,
wherein the cover base layer (461) includes:
a first cover portion (4611) corresponding to the conductive layer (462, 463); and
a second cover portion (4612) corresponding to the insulating layer (464).

9. The circuit board (400) of any one of claims 1 to 8,
wherein the shielding layer (440) includes:
a first shielding portion (441) corresponding to the conductive layer (462, 463); and
a second shielding portion (442) corresponding to the insulating layer (464).

10. The circuit board (400) of any one of claims 1 to 9, further comprising:
a ground line (490) connecting the shielding layer (440) and the power line (410, 420).

11. The circuit board (400) of any one of claims 1 to 10, further comprising:
a conductive adhesive layer (496) at least partially disposed between the cover layer (460) and the shielding layer (440) and connected to the power line (410, 420).

12. The circuit board (400) of claim 11,
wherein the conductive adhesive layer (496) includes:
a first conductive adhesive portion (497) disposed between the cover layer (460) and the shielding layer (440); and
a second conductive adhesive portion (498) extending from the first conductive adhesive portion (497), and connecting the shielding layer (440) and the power line (410, 420).

13. The circuit board (400) of any one of claims 1 to 12,
wherein the conductive layer (462, 463) is electrically connected to the power line (410, 420), and configured to provide a ground to the power line (410, 420).

14. The circuit board (400) of any one of claims 1 to 13,
wherein a first gap (h1, h2) between the power line (410, 420) and the conductive layer (462, 463) is smaller than a second gap (h3) between the signal line (430) and the shielding layer (440).

15. The circuit board (400) of any one of claims 1 to 14, further comprising:
an adhesive layer (480) disposed between the power line (410, 420) and the cover layer (460), and surrounding the power line (410, 420).
